# EUROPEAN PATENT SPECIFICATION

(11) **EP 1 585 101 B1**
(45) Date of publication and mention of the grant of the patent: **10.03.2010**
(21) Application number: 04025094.6
(22) Date of filing: 21.10.2004
(51) Int. Cl.: G09G 3/34, G09G 3/36, G03F 7/20

(54) **Spatial light modulator and method of performing photolithography using the same**
Räumlicher Lichtmodulator und photolithographisches Verfahren mit dessen Anwendung
Modulateur spatial de lumière et procédé de photolithographie utilisant celui-ci

(30) Priority: 26.03.2004 US 810414
(43) Date of publication of application: 12.10.2005
(73) Proprietor: Avago Technologies Fiber IP (Singapore) Pte. Ltd., Singapore 768923 (SG)
(72) Inventor: Schroeder, Dale W., Scotts Valley, CA 95066 (US)
(74) Representative: Dilg, Haeusler, Schindelmann Patentanwaltsgesellschaft mbH

(56) References cited:
- US-A- 3 374 463
- US-A- 5 696 803
- US-A1- 2002 092 993

## Description

### CROSS-REFERENCE TO RELATED APPLICATIONS

This application is related by subject matter to U.S. Utility Applications for Serial No. 10/810,067, entitled BUFFERS FOR LIGHT MODULATION ELEMENTS IN SPATIAL LIGHT MODULATORS; and Serial No. 10/811,407, entitled SPATIAL LIGHT MODULATOR AND METHOD FOR INTERLEAVING DATA, each filed on an even date herewith.

### BACKGROUND OF THE INVENTION

### Technical Field of the Invention

The present invention relates generally to photolithography, and more specifically, to dynamic photolithography systems.

### Description of Related Art

Recently, dynamic photolithography systems have been developed that employ a spatial light modulator (SLM) to define a pattern that is imaged onto a substrate having a photosensitive surface, such as a layer of photoresist. SLMs are electrical devices that include individually controllable light modulation elements (e.g., liquid crystal cells or micromirrors) that define pixels of an image in response to electrical signals. Typically, at small feature sizes (e.g., 5 µm or smaller), there are tens of millions of light modulation elements within an SLM that is not more than a few square centimeters in area. For example, an SLM including an array of 16,384 columns by 606 rows of 3 µm light modulation elements has been proposed for use in transferring such small feature sizes.

With the small SLM size, multiple exposures are generally required to image the entire area of the substrate. Since the image formed by the SLM is easily reconfigurable, it is a relatively simple process to divide the final image into sections, configure the SLM to transfer one of the image sections onto the appropriate area of the substrate surface, shift the relative position of the substrate and SLM and repeat the process for each image section until the entire image is transferred onto the substrate surface.

However, with the large number of light modulation elements, it is impracticable to assume that the SLM will be free from defects. Statistically, there will be at least a few of the tens of millions of light modulation elements of the SLM that are defective. As a result of the multiple imaging process, each defective light modulation element produces N pixel defects on the substrate surface, where N is the number of sections the image is divided into. To limit the number of defects in the transferred image caused by defective light modulation elements, the data can be shifted through the SLM to transfer each image section onto the same portion of the substrate multiple times using different light modulation elements in the SLM, as described in co-pending and commonly assigned U.S. Application for Patent Serial No. 10/737,126.

Strobe lines within the SLM provide strobe signals to the light modulation elements to drive the data shifting between the light modulation elements. However, due to the small size and the high aspect ratio (length to width) of SLMs, circuit loading and strobe line resistance limit the strobe frequencies to unacceptably low values, while also introducing significant clock skew across the SLM. In addition, when the strobe lines are configured to run the length of the SLM, failure points or shorts in the strobe lines can render the entire SLM unusable by preventing data shifting through the SLM. Therefore, what is needed is a strobe mechanism to increase the operational frequency of the strobe lines, reduce clock skew and limit damage from strobe line failure in SLM.

US 3,374,463 relates to a shift and rotate circuit for a data processor. The shift and rotate circuit is provided to shift and rotate a data word appearing at the output of an OR gate. In an embodiment, the circuit comprises five rows and sixteen columns of nodes to operate on 16-bit data words. Herein a node is merely a point, e.g., a designated spot on a conductor. Vertical and diagonal transmission paths are provided. The control of these paths is determined by a steering word. Four bits of the steering word determine the paths of the data bits through the network of nodes. A bit in the steering word controls the operation of gates connecting the nodes in one row to the nodes in a subsequent row.

### SUMMARY OF THE INVENTION

Embodiments of the present invention provide an electronic circuit that can be used in a spatial light modulator, for example. The electronic circuit includes circuit elements arranged in an array. The circuit elements are alterable in response to data stored therein, and are configured to shift data between the circuit elements. A strobe line is electrically coupled to a set of the circuit elements arranged such that at least two of the circuit elements in the set are positioned diagonally adjacent one another in the array. The strobe line provides a strobe signal to the set of light modulation elements to cause the data to be shifted to circuit elements outside of the set.

In one embodiment, the strobe line is alternately electrically coupled to orthogonally-adjacent and diagonally-adjacent circuit elements. For example, the strobe line can be electrically coupled to circuit elements in an alternating pattern of two horizontally-adjacent circuit elements and two diagonally-adjacent circuit elements to reduce the number of strobe lines compared with a purely diagonal arrangement, while maintaining the benefits of shorter strobe lines.

Other embodiments of the present invention provide a process for performing photolithography using an array of light modulation elements. The array includes strobe lines electrically coupled to respective sets of the light modulation elements. At least one of the sets includes light modulation elements that are positioned diagonally adjacent one another in the array. Data representing an image is loaded into the array. Certain ones of the light modulation elements are altered in response to the data loaded into the light modulation elements to transfer an instance of the image onto a substrate. Strobe signals are applied to the strobe lines to shift the data between the light modulation elements. Additional ones of the light modulation elements are altered in response to the shifted data to transfer another instance of the image onto the substrate.

Extending the strobe lines generally diagonally across the light modulation element array reduces the length of the strobe lines. This allows the operational frequency of the spatial light modulator to be increased by about three orders of magnitude (x1000) and reduces clock skew. In addition, extending the strobe lines generally diagonally results in strobe lines running across only a portion of the total width of the spatial light modulator, which limits the extent of damage resulting from strobe line failure to a smaller portion of the array. Furthermore, the invention provides embodiments with other features and advantages in addition to or in lieu of those discussed above. Many of these features and advantages are apparent from the description below with reference to the following drawings.

### BRIEF DESCRIPTION OF THE DRAWINGS

The disclosed invention will be described with reference to the accompanying drawings, which show sample embodiments of the invention and which are incorporated in the specification hereof by reference, wherein:
FIG. 1 illustrates a photolithography system utilizing a spatial light modulator to photolithographically transfer an image to a substrate in accordance with embodiments of the present invention;
FIG. 2 is a block diagram illustrating a computing system operable to control the photolithography system of FIG. 1;
FIG. 3 is a schematic of an exemplary spatial light modulator for shifting data through the spatial light modulator, in accordance with embodiments of the present invention;
FIG. 4A is a block diagram illustrating an exemplary interconnection of light modulation elements within the spatial light modulator of FIG. 3;
FIG. 4B is a timing diagram for shifting data between the light modulation elements;
FIG. 5 is a block diagram of an exemplary configuration of the spatial light modulator;
FIG. 6 is a representation of a strobe line configuration of the spatial light modulator, in accordance with embodiments of the present invention;
FIG. 7 is representation of a strobe line configuration of the spatial light modulator, in accordance with other embodiments of the present invention;
FIG. 8 illustrates an exemplary substrate exposure timing sequence;
FIG. 9 is a flow chart illustrating an exemplary process to provide strobe signals to light modulation elements within a spatial light modulator to shift data between light modulation elements; and
FIG. 10 is a flow chart illustrating an exemplary process for shifting data within a spatial light modulator to dynamically photolithographically transfer an image onto a substrate.

### DETAILED DESCRIPTION OF EXEMPLARY EMBODIMENTS

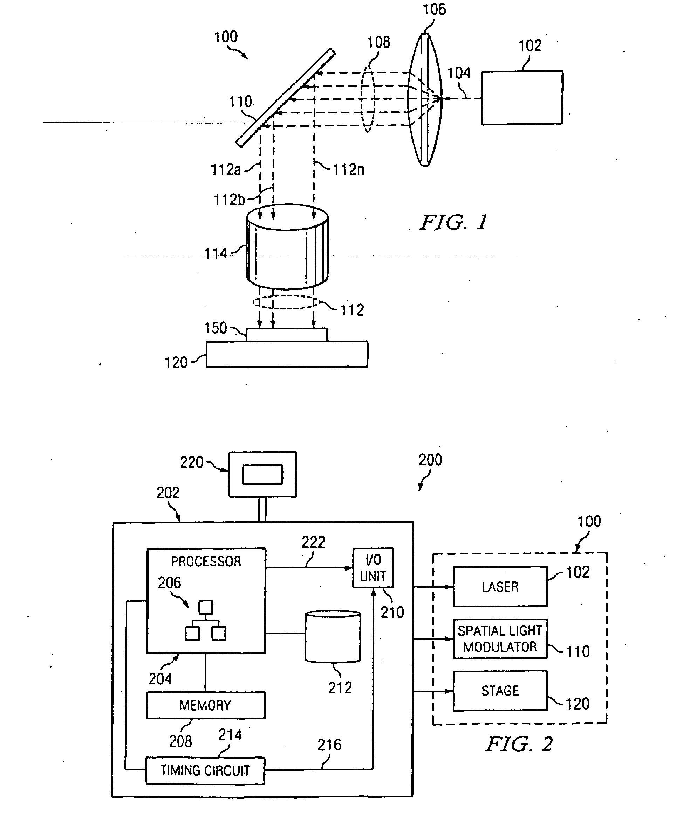

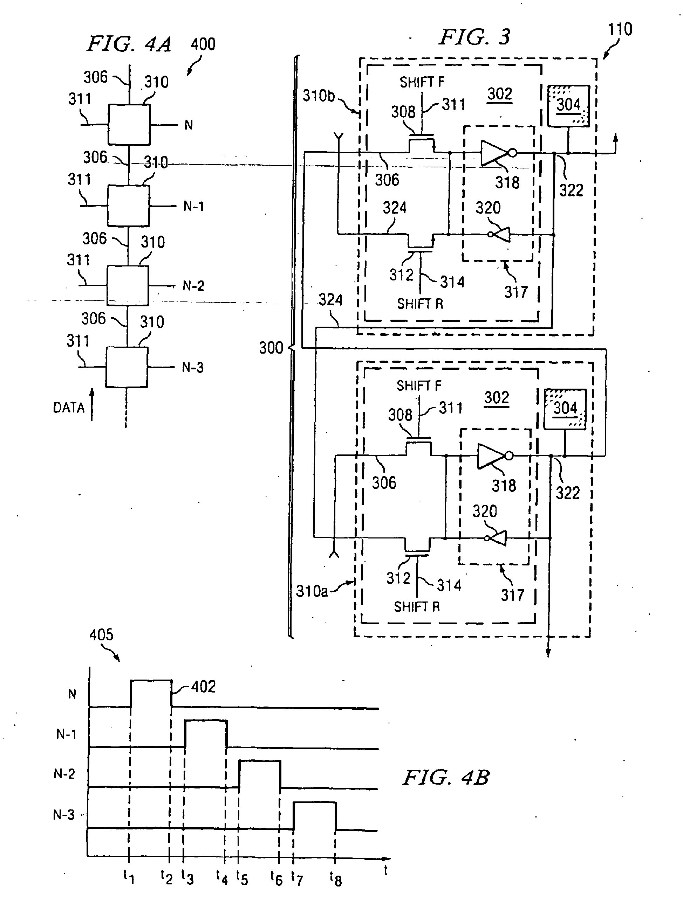

FIG. 1 illustrates a dynamic photolithography system 100 for photolithographically transferring an image to a substrate 150. The photolithography system 100 includes a light source 102 operable to output light 104. The light source 102 can be a laser, such as an excimer laser, or other non-laser source, as understood in the art. The light source 102 is optically coupled to beam shaping optics 106. The output of the beam shaping optics 106 is light 108 that is directed toward a spatial light modulator 110 in accordance with embodiments of the invention. The spatial light modulator 110 includes light modulation elements (not shown) operable to selectively transfer the light 108. The light modulation elements are described in more detail below in connection with FIG. 3. In one embodiment, the light modulation elements are liquid crystal elements. However, it should be understood that in other embodiments, the light modulation elements are micromirrors or another type of optical device that can selectively transfer light by reflection, transmission or otherwise.

The output of the spatial light modulator 110 includes dark areas with no light and light areas made up of multiple light beams 112a - 112n (collectively 112) that are transferred by selected light modulation elements to form at least a portion of an image containing a pattern. The light beams 112 are directed to projection optics 114, which is optically aligned to direct the light beams 112 onto the substrate 150. A photosensitive layer (not shown), such as a layer of photoresist, is on the surface of the substrate 150. The photosensitive layer reacts in response to the light beams 112 to produce the pattern on the surface of the substrate 150. In one embodiment, the substrate 150 is mounted on a scanning stage 120 to move the substrate 150 in any direction relative to the spatial light modulator 110. The scanning stage 120 can be, for example, a high precision scanning stage. In another embodiment, the substrate 150 remains stationary and the optics and/or light beams 112 move relative to the substrate 150. In either configuration, one of the substrate 150 and the spatial light modulator 110 is moved relative to the other to transfer the image onto the substrate 150.

The spatial light modulator 110 further includes pixel drive circuits (not shown) that are uniquely coupled to the light modulation elements. The pixel drive circuits are described in more detail below in connection with FIG. 3. The pixel drive circuits store data that define the state of the light modulation elements. For example, light modulation elements that are reflective can be selectively altered to be in a reflective or non-reflective state such that the received light 108 is either reflected or not reflected onto the substrate 150 by storing data (e.g., logical LOW and HIGH data values) in pixel drive circuits associated with the light modulation elements. In effect, the spatial light modulator 110 operates as a dynamic mask that forms a pattern that is imaged onto the photosensitive layer of the substrate 150.

FIG. 2 is a block diagram illustrating the configuration 200 of a computing system 202 operable to control the photolithography system 100 of FIG. 1. The computing system 202 includes a processing unit 204 operable to execute software 206. The processing unit 204 can be any type of microprocessor, microcontroller, programmable logic device, digital signal processor or other processing device. The processing unit 204 is coupled to a memory unit 208 and input/output (I/O) unit 210. The I/O unit 210 can be wired or wireless. The processing unit 204 is further coupled to a storage unit 212 and timing circuit 214 that generates timing signals 216 for the photolithography system 100. An electronic display 220 is optionally coupled to the computing system 202 and operable to display an image (or portion of an image) that is to be communicated to the spatial light modulator 110 for imaging onto the substrate 150 of FIG. 1.

The timing signals 216 control the operation of the stage 120, spatial light modulator 110 and laser 102 during exposure cycles. Examples of timing signals 216 include data clock signals to sequentially clock data 222 representing a portion of an image into the spatial light modulator 110, strobe signals provided along strobe lines within the spatial light modulator 110 to shift data between light modulation elements of the spatial light modulator 110, exposure signals to initiate a flash of the laser 102, and other clock signals to drive the spatial light modulator 110, laser 102 and stage 120. The processor 204 communicates with the timing circuit 214 and I/O unit 210 to communicate the data 222 and timing signals 216 to the spatial light modulator 110 and other components of the photolithography system 100, such as the laser 102 and stage 120. For example, during an exposure cycle, data 222 is shifted between light modulation elements within the spatial light modulator 110 by strobe signals, data 222 is transmitted from the computing system 202 to the spatial light modulator 110 in response to a data clock signal and the other clock signals drive the SLM 110, stage 120 and laser 102 to alter the state of light modulation elements within the SLM 110 as a function of the data 222, to align the stage 120 with the SLM 110 for image transfer and to control the timing of the exposure signal to initiate the laser 102 flash.

To reduce defects in the transferred image due to light modulation element defects, the data 222 communicated to the SLM 110 during each exposure cycle includes only a portion of the image to enable optical oversampling of the image on the substrate. An example of an optical oversampling technique is described in co-pending and commonly assigned U.S. Applications for Patent Serial Nos. 10/737,126 and 10/736,090.

In one embodiment, the image is divided into sections, with each section transferred by the SLM 110 during a single exposure cycle. In addition, each section is divided into subsections, such that the data 222 sent to the SLM 110 represents at least one of the image subsections. The data representing the remaining image subsections of a particular image section are shifted within the SLM 110 to enable the remaining image subsections to be imaged by different light modulation elements of the SLM 110.

For example, in one implementation embodiment, if each image section is divided into six image subsections, the data 222 includes data previously transferred to the substrate that represents five image subsections and data representing one new image subsection. However, with potentially tens of millions of light modulation elements, writing the data 222 representing all of the image subsections to the SLM 110 during each exposure cycle requires a large amount of data 222 to be communicated between the I/O unit 810 and the SLM 110. Such a large I/O bandwidth increases the power consumption and limits the throughput speed of the photolithography system 100. Therefore, in other implementation embodiments, the data 222 communicated to the SLM 110 during each exposure cycle includes only that representing the new image subsection(s) and not that representing any of the previously transferred image subsections in order to reduce bandwidth, thereby reducing power consumption and increasing throughput speed. The data representing the image subsections previously transferred to the substrate are stored within the SLM 110 and moved internally within the SLM 110.

FIG. 3 is a schematic of a portion of an exemplary spatial light modulator 110 capable of moving data internally during a photolithographic process. The SLM includes an array 300 of circuit elements, hereinafter referred to as light modulation elements 310a and 310b (collectively 310), each including a memory element 302 in communication with an associated pixel controller 304 that is at least partially responsible for controlling the state of a pixel defined by the light modulation element 310. In FIG. 3, each memory element 302 is a static memory element that includes an input line 306 and a forward access control element 308. In the example shown, the forward access control element 308 is a transistor having a forward access strobe line 311 that is operable to control the state of the forward access control element 308 during a shift forward operation. In FIG. 3, a shift forward operation shifts data up from light modulation element 310a to light modulation element 310b. Each memory element 302 further includes a reverse access control element 312 having a reverse access strobe line 314 operable to control the state of the reverse access control element 312 during a shift reverse operation. In FIG. 3, a shift reverse operation shifts data down from light modulation element 310b to light modulation element 310a.

Depending on the configuration of the array 300, light modulation elements 310a and 310b are either positioned in different columns of the same row or in different rows of the same column. Thus, the memory elements 302 are configured to shift data bi-directionally between adjacent rows or columns of the array 300. In addition, it should be understood that in other embodiments, the memory elements 302 can additionally or alternatively be configured to shift the data between non-adjacent rows, columns or light modulation elements 310 of the array 300.

A common node 316 of the forward and reverse access control elements 308 and 312, respectively, is coupled to a memory cell 317. In one embodiment, the memory cell 317 is a bi-stable circuit or static latch utilized to store data representing one pixel of the image. The memory cell 317 is shown implemented as a latch (i.e., a switch and back-to-back inverters) that uses a ripple clock to propagate data between memory cells 317. The ripple clock is described in more detail below with reference to FIGs. 4-7.

Each memory cell 317 includes a forward inverter 318 and a feedback inverter 320. The feedback inverter 320 is a "weak" feedback element that is utilized to reinforce the current state (i.e., LOW or HIGH state) to a stable position. Thus, if the common node 316 is in a low voltage level (i.e., a LOW state), the forward inverter 318 inverts the LOW state to a HIGH state on the output coupled to output node 322. The HIGH state on output node 322 is an input to the feedback inverter 320, which outputs a low voltage level onto node 316. The low voltage level output from the weak feedback inverter 320 reinforces, but does not control, the LOW state on node 316. Similarly, a high voltage level output from the weak feedback inverter 320 reinforces, but does not control, the HIGH state on node 316.

The output node 322 is coupled to the pixel controller 304 and is also the output node of the light modulation element 310. In one embodiment, the pixel controller 304 is a pixel electrode of a liquid crystal (LC) light modulation element. The voltage level on output node 322 is applied to the pixel electrode of the LC light modulation element to alter the state of the LC light modulation element when the voltage level applied to the pixel electrode differs from a voltage applied to a common electrode of the LC light modulation element. In other embodiments, the pixel controller 304 is an electromechanical device controlling the state or position of a micromirror.

Multiple light modulation elements 310 are electrically interconnected. In one embodiment, the light modulation elements 310 are connected in a shift register configuration, as shown in FIG. 3. In the shift register configuration, the output node 322 of a first light modulation element (e.g., light modulation element 310a) is connected to the input line 306 of a second light modulation element (e.g., light modulation element 310b). The output node 322 of the second light modulation element 310b is connected to the input line of a third light modulation element (not shown), and so on until the output node of the (N-1)th pixel (not shown) is connected to the input line 306 of the Nth pixel (not shown), thereby forming a forward connection network. To load input data into the forward connection network, the input data is provided at the input line 306 of the first light modulation element 310a, and data is shifted from the first light modulation element 310a to the second light modulation element 310b when a strobe signal is received on forward access strobe line 311 of light modulation element 310a, and so on. It should be understood that a similar data loading and shifting configuration can be implemented for a reverse connection network, where data is input to the last light modulation element 310 in the array 300.

FIG. 4A is a block diagram of an exemplary high-level shift register configuration 400 of the light modulation elements 310. The light modulation elements 310 have forward access strobe lines 311 coupled thereto for causing data on the input lines 306 to propagate through the memory elements 302 (shown in FIG. 3) in the forward direction. The light modulation elements 310 can be viewed as elements N, N-1, N-2, N-3, and so forth, where the Nth light modulation element 310 is the last light modulation element and the (N-3)rd light modulation element 310 is the first light modulation element. The shift register configuration 400 can cause data to propagate between adjacent and/or non-adjacent rows and/or columns of an array of light modulation elements 310.

FIG. 4B is a timing diagram 405 for shifting data between the light modulation elements in the shift register configuration 400 shown in FIG. 4A. As shown in FIG. 4B, a sequence of non-overlapping strobe signals, produced by a ripple clock or otherwise, is utilized to shift the data through the light modulation elements. As shown, a strobe signal 402 is applied to the forward access control element 308 of the Nth light modulation element via forward access strobe line 311 between times t₁ and t₂ to move data out of the Nth light modulation element. Each of the other strobe signals 402 for the memory elements of the (N-1)th, (N-2)th and (N-3)th light modulation elements are pulsed sequentially such that the data is moved serially from the (N-1)th light modulation element to the Nth light modulation element between times t₃ and t₄, from the (N-2)th light modulation element to the (N-1)th light modulation element between times t₅ and t₆ and from the (N-3)th light modulation element to the (N-2)th light modulation element between times t₇ and t₈ so as to ensure the data is preserved as it is shifted through the light modulation elements. It should be understood that a similar shifting mechanism can be used to shift data in a reverse sequence to enable bi-directional data movement.

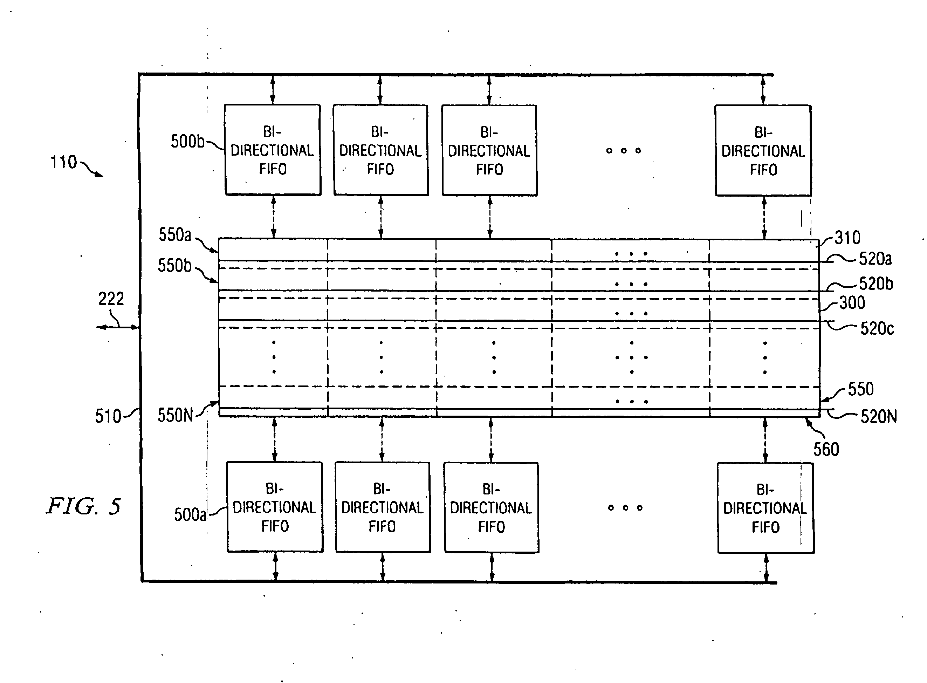

FIG. 5 is a block diagram of an exemplary configuration of the spatial light modulator 110 of FIG. 3 with the light modulation elements 310 arranged in a shift register configuration similar to that shown in FIG 4A. The array 300 of light modulation elements 310 is shown arranged in rows 550 and columns 560. There are more columns 560 than rows 550, resulting in a spatial light modulator 110 with a high aspect ratio. In the example shown in FIG. 5, the light modulation elements 310 are configured to shift data between rows 550 of the array 300. However, it should be understood that in other embodiments, the light modulation elements can be configured to shift data between columns 560 of the array 300.

In one embodiment, strobe lines 520a, 520b...520N connected to forward access strobe lines 311 (shown in FIG. 3) of individual light modulation elements 310 run the length of the rows 550 to shift data between the rows 550. Thus, as a strobe signal is sent down each of the strobe lines, the data is shifted between rows 550. For example, assuming the data is shifted up in the array 300, at an initial time (e.g., t₁) a first strobe signal is sent down the strobe line 520a on row 550a of light modulation elements 310 to shift the data in row 550a of light modulation elements 310 out of the array 300. At a subsequent time (e.g., t₂), a second strobe signal is sent down the strobe line 520b on row 550b of the array 300 to shift the data from the light modulation elements 310 in row 550b to the light modulation elements 310 in row 550a. This process is continued until a strobe signal is sent down the strobe line 520N on row 550N of light modulation elements 310 to shift up the data in row 550N of light modulation elements 310.

In other embodiments, data 222 is input to the light modulation elements 310 via bus 510 and buffers 500a and 500b (collectively 500). Each buffer 500 is a bi-directional first-in-first-out (FIFO) buffer that stores and loads data 222 into the light modulation elements 310 associated with the buffer 500. In one embodiment, each buffer 500 loads data 222 into a single column 560 of the array 300. In another preferred embodiment, each buffer 500 loads data 222 into multiple columns 560 of the array 300. For example, after the data in the light modulation elements 310 in row 550N is shifted up, new data 222 is loaded into row 550N of light modulation elements 310 from buffers 500a. The data 222 output from the light modulation elements 310 in row 550a is additionally input to buffers 500b, which delay the data by a time corresponding to the time required to shift data from row 550N to row 550a. The data shifted out of row 550a can then be compared to the delayed original input data to determine if errors occurred during the data shifting and to identify potentially defective light modulation elements.

However, due to the small size and the high aspect ratio of the SLM 110, circuit loading and strobe line resistance limit the operating frequency, while also introducing significant clock skew across the SLM 110, i.e., along the strobe lines 520a-520N. In addition, failure points or shorts in the strobe lines that run the length of the rows 550 can render the entire SLM 110 unusable by preventing data shifting through the SLM 110.

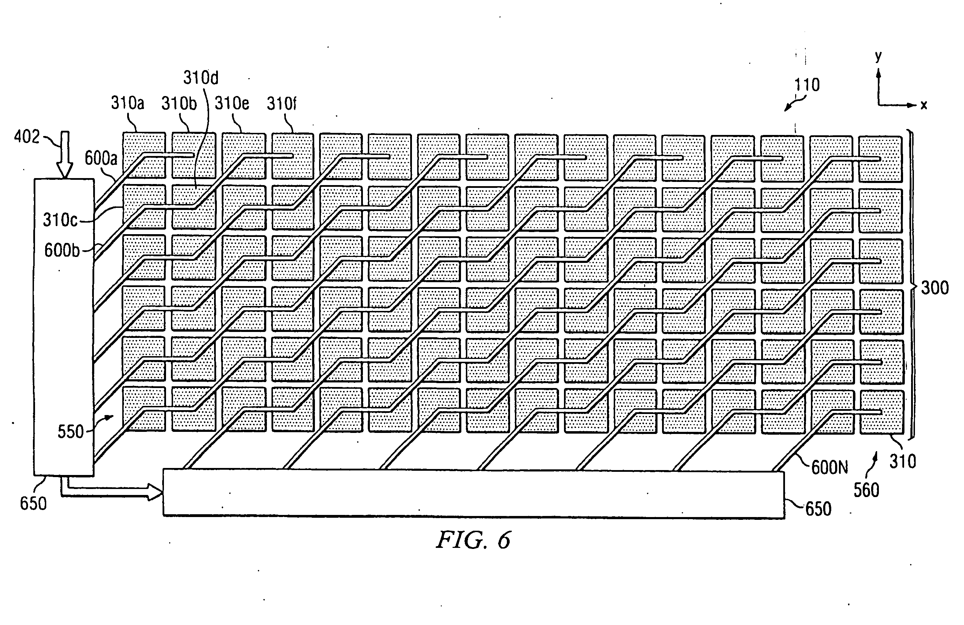

Therefore, in accordance with embodiments of the present invention, an improved strobe line configuration is shown in FIG. 6. The strobe line configuration shown in FIG. 6 can be used with the SLM 110 configuration shown in FIG. 5. In FIG. 6, the strobe lines 600a...600N (collectively referred to herein as 600) extend generally diagonally across the array 300 of light modulation elements 310 to shorten the length of the strobe lines 600. As used herein, the term "diagonal" means passing through at least two non-orthogonal light modulation elements 310, where "non-orthogonal" means positioned in different rows and different columns of the array 300. Diagonally-extending strobe lines 600 increase the operational frequency of the strobe signal, reduce clock skew and limit the scope of damage arising from strobe line failure to a portion of the array 300. Each strobe line 600 is electrically coupled to at least two light modulation elements 310 that are non-orthogonally positioned within the array 300 with respect to one another. Those of the light modulation elements 310 coupled to each of the strobe lines 600 constitute a set of the light modulation elements 310. It should be understood that although the strobe lines 600a...600N are shown coupled to the light modulation elements 310 with electrical conductors throughout the Figures, the strobe lines 600a...600N could alternatively be coupled to the light modulation elements 310 by intervening circuits, such as buffers, as described in co-pending and commonly assigned U.S. Application for Patent Serial No. 10/810,067.

In one embodiment, the strobe lines are alternately coupled to orthogonally-adjacent and diagonally-adj acent light modulation elements 310 to reduce the number of strobe lines 600 compared with strobe lines that run purely diagonally. For example, as shown in FIG. 6, the strobe lines 600 are alternately coupled to two horizontally-adjacent, i.e., adjacent in the x-direction, and two diagonally-adjacent light modulation elements 310. Alternatively, the number of horizontally-adjacent and/or diagonally-adjacent light modulation elements 310 may be greater than two. In another example in which the data is shifted between columns of the array 300, the strobe lines 600 are alternately coupled to two or more vertically adjacent, i.e., adjacent in the y-direction, and two or more diagonally-adjacent light modulation elements 310. In another embodiment, the strobe lines 600 are coupled to only diagonally-adjacent light modulation elements 310. Such a connection minimizes the length of the strobe lines. It should be understood that numerous strobe line 600 configurations that connect to diagonally positioned light modulation elements are possible, and the present invention is not limited to any particular strobe line 600 configuration.

In the example shown in FIG. 6, strobe line 600a provides a strobe signal to light modulation elements 310a and 310b that are horizontally-adjacent one another, i.e., that are adjacent in the x-direction, to shift the data out of light modulation elements 310a and 310b, and strobe line 600b provides a strobe signal to light modulation elements 310c-f that are alternately horizontally-adjacent and diagonally-adjacent. Light modulation elements 310c and 310d are horizontally-adjacent and are vertically adjacent, i.e., adjacent in the y-direction, to light modulation elements 310a and 310b, respectively. Therefore, a strobe signal distributed by strobe line 600b causes data to be shifted out of light modulation elements 310c and 310d and into light modulation elements 310a and 310b, respectively. Light modulation element 310e is diagonally-adjacent light modulation element 310d and horizontally-adjacent light modulation element 310f. The strobe signal distributed by strobe line 600b causes data to be shifted out of light modulation elements 310e and 310f.

Each strobe line 600 is sequentially accessed using a shift register 650 that implements a digital delay line using a ripple clock to control the timing of the data shifting between the light modulation elements. For example, when a strobe signal 402 is sent from the timing circuit (214, shown in FIG. 2), the strobe signal 402 is input to the shift register 650 and is clocked through the shift register 650 to sequentially provide the strobe signal 402 to each of the strobe lines 600, starting with a strobe line 600a that shifts data out of light modulation elements 310a and 310b and ending with a strobe line 600N that shifts data into the light modulation elements 310 connected to strobe line 600N. In one embodiment, the strobe lines 600 have a consistent pattern across the entire area of the array 300.

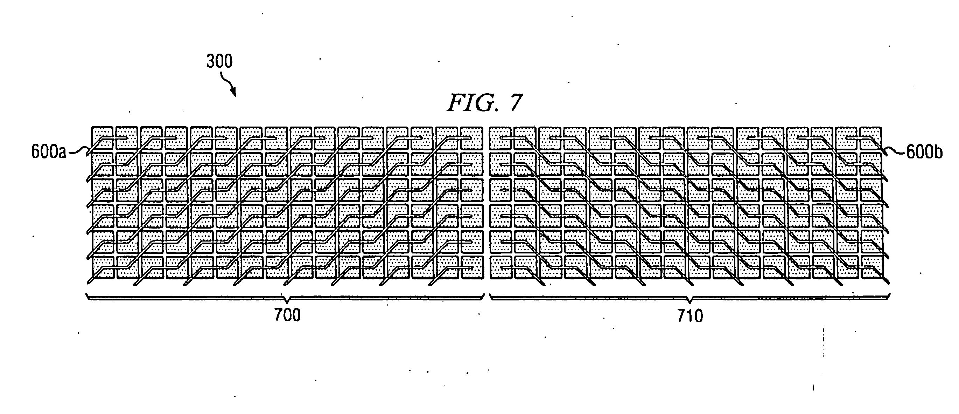

In other embodiments, as shown in FIG. 7, the strobe lines 600 are arranged in a first pattern across a first portion 700 of the array 300 and in a second pattern across a second portion 710 of the array 300. For example, in FIG. 7, the strobe lines 600 are arranged in two patterns that mirror one another, and the mirroring strobe lines 600a and 600b in each portion 700 and 710 of the array 300, respectively, can be accessed simultaneously to increase the operational frequency of the strobe lines 600 of spatial light modulator 110.

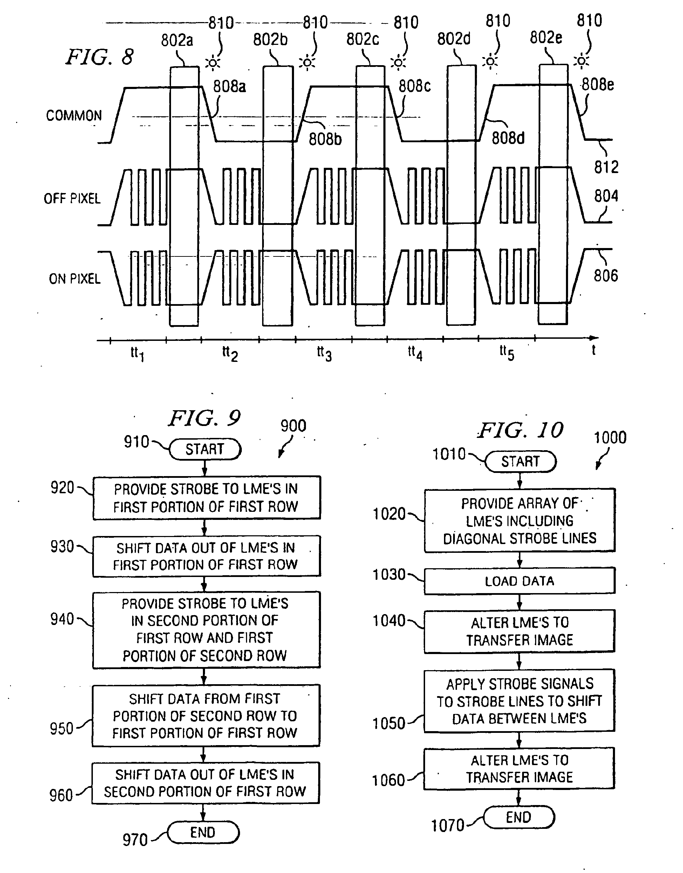

FIG. 8 illustrates an exemplary substrate exposure timing sequence using data shifting. FIG. 8 shows a series of liquid crystal (LC) settling intervals 802a - 802e (collectively 802) during which the LC material settles between exposures. At the end of each LC settling interval 802, the laser is flashed (represented by 810). Between consecutive LC settling intervals 802, there are transition time intervals tt₁ - tt₅. During each of the transition time intervals tt₁ - tt₅, data is moved between the memory elements within the SLM in preparation for the next exposure. The timing circuit 214 (shown in FIG. 2) can be utilized to apply the strobe signals to the strobe lines 600 (shown in FIG. 6) to drive the data propagation.

The electrical state of a common electrode signal 812 alternates between consecutive ones of time intervals tt₁ - tt₅. Transitions 808a-808e of the common electrode signal 812 occur during the time intervals tt₁ - tt₅ after the laser flashes, shown at 810. In FIG. 8, two exemplary pixel electrode signals 804 and 806 are shown, where pixel electrode signal 804 is illustrative of that of an ON liquid crystal element and pixel electrode signal 806 is illustrative of that of an OFF liquid crystal element. At each laser flash 810, the pixel electrode signal 804 on the pixel electrode has the same potential as the common electrode, and the pixel electrode signal 806 on the pixel electrode has the opposite potential as the common electrode. During the transition time intervals tt₁ - tt₅, data inversions are performed as data is shifting through the memory array to maintain DC balance of the liquid crystal elements. In one embodiment, the data is shifted between the memory elements of the light modulation elements during the transition time intervals tt₁ - tt₅ in about 60 microseconds, which allows 940 microseconds of a one millisecond duty cycle for the liquid crystal material to respond to the electric field applied between the pixel electrode and the common electrode. A twenty-nanosecond (20 ns) flash of the laser 810 occurs at the end of each of the LC settling intervals 802 after the liquid crystal material has transitioned. It should be understood that other timings can be established to increase or decrease the LC settling intervals 802 and data shifting rates based on the transition rate of the liquid crystal material and speed of the substrate moving with respect to the spatial light modulator.

FIG. 9 is a flow chart illustrating an exemplary process 900 to provide strobe signals to light modulation elements within a spatial light modulator to shift data between light modulation elements. The process starts at block 910. At block 920, a first strobe signal is applied to the light modulation elements in a first portion of a first row of an array of light modulation elements to trigger the shifting of data out of the light modulation elements in the first portion of the first row at block 930. At block 940, a second strobe signal is applied to the light modulation elements in a second portion of the first row, adjacent the first portion in the first row and a first portion of a second row, adjacent the first portion in the first row. At block 950, the second strobe signal triggers the light modulation elements in the first portion of the second row to shift data from the light modulation elements in the first portion of the second row to the light modulation elements in the first portion of the first row. At block 960, the second strobe signal also triggers the light modulation elements in the second portion of the first row to shift data out of the light modulation elements in the second portion of the first row. The process ends at block 970.

FIG. 10 is a flow chart illustrating an exemplary process 1000 for shifting data within a spatial light modulator to dynamically photolithographically transfer an image onto a substrate. The photolithography process starts at block 1010. At block 1020, an array of light modulation elements is provided that includes strobe lines electrically coupled to respective sets of light modulation elements. At least one of the sets includes light modulation elements that are positioned diagonally adjacent one another in the array. For example, each set can include at least respective two light modulation elements positioned diagonally-adjacent one another in the array. As another example, each set of light modulation elements can include both diagonally-adjacent and orthogonally-adjacent light modulation elements to shift the data bi-directionally between rows and/or columns of the array.

At block 1030, data representing an image is loaded into light modulation elements within a spatial light modulator. At block 1040, the light modulation elements are altered in response to the data loaded thereinto. The altered light modulation elements are illuminated to direct an illumination pattern onto the substrate. At block 1050, strobe signals are provided to the strobe lines to shift the data between the light modulation elements. At block 1060, the light modulation elements are altered again in response to the data moved into them. The process ends at block 1070.

The innovative concepts described in the present application can be modified and varied over a wide rage of applications. Accordingly, the scope of patented subject matter should not be limited to any of the specific exemplary teachings discussed, but is instead defined by the following claims.

## Claims

1. An electronic circuit having circuit elements (310) arranged to form an orthogonal array (300) comprising rows (550) and columns (560), said circuit elements (310) being alterable in response to data (222) stored therein and configured to shift data (222) therebetween, said electronic circuit comprising:
a strobe line (600) electrically coupled to a set of said circuit elements (310) to provide thereto a strobe signal (402) to cause said circuit elements (310) in said set to shift the data (222) to ones of said circuit elements (310) outside said set, said set comprising at least two of said circuit elements (310) positioned diagonally adjacent one another in the array (300);
wherein diagonally-adjacent circuit elements are positioned non-orthogonally in different adjacent rows and in different adjacent columns of said array (300).

2. The electronic circuit of Claim 1,
wherein said set additionally comprises ones of said circuit elements (310) positioned orthogonally-adjacent in the array (300) and ones of said circuit elements (310) positioned diagonally-adjacent in the array (300); and
wherein orthogonally-adjacent circuit elements are positioned in the same column but in different adjacent rows, or in the same row but in different adjacent columns of said array (300).

3. The electronic circuit of Claim 2,
wherein said strobe line (600) is electrically coupled to a first one and a second one of said circuit elements (310), said first one and said second one of said circuit elements (310) being horizontally-adjacent, said strobe line (600) being additionally electrically coupled to a third one of said circuit elements (310) diagonally-adjacent said second one of said circuit elements (310); and
wherein horizontally-adjacent circuit elements are positioned in the same row but in different adjacent columns of said array (300).

4. The electronic circuit of Claim 1, wherein said circuit elements (310) are configured to shift data (222) bi-directionally between orthogonally-located ones of said circuit elements (310); and wherein orthogonally-located circuit elements are positioned in the same column but in different rows, or in the same row but in different columns of said array.

5. The electronic circuit of any of Claims 1 to 4, wherein said circuit elements (310) are light modulation elements, said light modulation elements (310) including:
memory elements (302) configured to store the data (222) and shift the data (222) therebetween; and
pixel controllers (304) configured to alter the state of respective ones of said light modulation elements (310) in response to the data (222) stored in respective ones of the memory elements (302).

6. The electronic circuit of Claim 5, wherein each of said memory elements (302) further includes an output node (322) electrically coupled to said respective pixel controller (304) and to an input node (306) of an additional one of said memory elements (302).

7. The electronic circuit of any of Claims 1 to 6, wherein:
said electronic circuit additionally comprises additional strobe lines (600); and
said strobe lines (600) are configured in a first pattern covering a first group (700) of said circuit elements (310) and in a second pattern covering a second group (710) of said circuit elements (310), the second pattern mirroring the first pattern.

8. The electronic circuit of Claim 1, wherein said electronic circuit additionally comprises:
additional strobe lines (600); and
a shift register (650) electrically connected to said strobe lines (600) to apply strobe signals (602) sequentially thereto.

9. A method of performing photolithography, said method comprising:
providing (1020) an orthogonal array of light modulation elements, said array comprising rows, columns and strobe lines electrically coupled to respective sets of said light modulation elements, at least one of said sets comprising ones of the light modulation elements positioned diagonally adjacent one another in said array; wherein diagonally adjacent circuit elements are positioned non-orthogonally in different adjacent rows and in different adjacent columns of said array;
loading (1030) data representing an image into said array; altering (1040) ones of the light modulation elements in response to said data to transfer an instance of the image onto a substrate;
applying (1050) strobe signals to said strobe lines to shift said data between said light modulation elements; and
altering (1060) ones of the light modulation elements in response to said data shifted thereinto to transfer another instance of the image onto the substrate.

10. The method of Claim 9, wherein said at least one of said sets additionally comprises ones of said light modulation elements positioned orthogonally-adjacent in said array and ones of said light modulation elements positioned diagonally-adjacent in said array;
wherein orthogonally adjacent circuit elements are positioned in the same column but in different adjacent rows, or in the same row but in different adjacent columms of said array.

11. The method of Claim 9, wherein said applying further comprises:
applying (920) a first strobe signal to first ones of said light modulation elements in a first row;
in response to said first strobe signal, shifting (930) the data out of said first ones of said light modulation elements in said first row; applying (940) a second strobe signal to second ones of said light modulation elements in said first row and to first ones of said light modulation elements in a second row, adjacent said first ones of said light modulation elements in said first row;
in response to said second strobe signal, shifting (950) the data from said first ones of said light modulation elements in said second row to said first ones of said light modulation elements in said first row; and in response to said second strobe signal, shifting (960) the data out of said second ones of said light modulation elements in said first row.

## Patentansprüche

1. Elektronische Schaltung mit Schaltungselementen (310), welche angeordnet sind um ein orthogonales Array (300) zu bilden, welches Reihen (550) und Spalten (560) aufweist, wobei die Schaltungselemente (310) veränderbar sind in Reaktion auf Daten (222), welche darin gespeichert sind, und konfiguriert sind zum dazwischen Verschieben von Daten (222), die elektronische Schaltung enthaltend:
eine Abtastleitung (600), welche elektrisch gekoppelt ist an einen Satz der elektrischen Schaltungselemente (310) zum daran Liefern eines Abtastsignals (402) zum Verursachen, dass die Schaltungselemente (310) in dem Satz die Daten (222) an welche der Schaltungselemente (210) außerhalb des Satzes verschieben, wobei der Satz mindestens zwei der Schaltungselemente (310) aufweist, die diagonal benachbart zueinander in dem Array (300) positioniert sind;
wobei die diagonal benachbarten Schaltungselemente nicht-orthogonal in verschiedenen benachbarten Reihen und in verschiedenen benachbarten Spalten des Arrays (300) positioniert sind.

2. Elektronische Schaltung nach Anspruch 1,
wobei der Satz zusätzlich welche der Schaltungselemente (310), die orthogonal benachbart in dem Array (300) positioniert sind, und welche der Schaltungselemente (310) aufweist, die diagonal benachbart in dem Array (300) positioniert sind, aufweist; und
wobei die orthogonal benachbarten Schaltungselemente in derselben Spalte, aber in verschiedenen benachbarten Reihen, oder in derselben Reihe, aber in verschiedenen benachbarten Spalten des Arrays (300) positioniert sind.

3. Elektronische Schaltung nach Anspruch 2, wobei die Abtastleitung (600) elektrisch mit einem ersten und einem zweiten der Schaltungselemente (310) gekoppelt ist, wobei das erste und das zweite der Schaltungselemente (310) horizontal benachbart sind, wobei die Abtastleitung (600) zusätzlich elektrisch mit einem dritten der Schaltungselemente (310), welches diagonal benachbart zu dem zweiten der Schaltungselemente ist, gekoppelt ist; und
wobei horizontal benachbarte Schaltungselemente in derselben Reihe, aber in verschiedenen benachbarten Spalten des Arrays (300) positioniert sind.

4. Elektronische Schaltung nach Anspruch 1, wobei die Schaltungselemente (310) konfiguriert sind zum Schieben von Daten (222) bidirektional zwischen orthogonal angeordneten der Schaltungselemente (310); und
wobei orthogonal angeordnete Schaltungselemente in derselben Spalte aber in verschiedenen Reihen, oder in derselben Reihe aber in verschiedenen Spalten des Arrays angeordnet sind.

5. Elektronische Schaltung nach einem der Ansprüche 1 bis 4, wobei die Schaltungselemente Lichtmodulationselemente sind, die Lichtmodulationselemente (310) enthaltend:
Speicherelemente (302), konfiguriert zum Speichern der Daten (222) und dazwischen verschieben der Daten (222); und
Pixelkontroller (304) konfiguriert zum Ändern des Zustands von entsprechenden der Lichtmodulationselemente (310) in Reaktion auf die Daten (222), die in entsprechenden der Speicherelemente (302) gespeichert sind.

6. Elektronische Schaltung nach Anspruch 5, wobei jedes der Speicherelemente (302) ferner einen Ausgangsknoten (322) aufweist, welcher elektrisch mit dem entsprechenden Pixelkontroller (304) und an den Eingangsknoten (306) eines zusätzlichen der Speicherelemente (302) elektrisch gekoppelt ist.

7. Elektronische Schaltung nach einem der Ansprüche 1 bis 6, wobei:
die elektronische Schaltung zusätzliche Abtastleitungen (600) aufweist; und
die Abtastleitungen (600) konfiguriert sind in einem ersten Muster, welches eine erste Gruppe (700) der Schaltungselemente (310) abdeckt, und in einem zweiten Muster, welches eine zweite Gruppe (710) der Schaltungselemente (310) abdeckt, wobei das zweite Muster das erste Muster spiegelt.

8. Elektronische Schaltung nach Anspruch 1, wobei die elektronische Schaltung zusätzlich aufweist:
zusätzliche Abtastleitungen (600); und
ein Schieberegister (650), welches mit den Abtastleitungen (600) elektrisch verbunden ist, um an diese sequenziell Abtastsignale (602) anzulegen.

9. Verfahren des Durchführens von Fotolithographie, das Verfahren enthaltend:
Bereitstellen (1020) eines orthogonalen Arrays von Lichtmodulationselementen, wobei das Array Reihen, Spalten und Abtastleitungen, welche elektrisch an entsprechende Sätze der Lichtmodulationselemente gekoppelt sind, aufweist, wobei mindestens einer der Sätze welche der Lichtmodulationselemente enthält, die diagonal benachbart zueinander in dem Array positioniert sind;
wobei diagonal benachbarte Schaltungselemente nicht-orthogonal in verschiedenen benachbarten Reihen und in verschiedenen benachbarten Spalten des Arrays positioniert sind;
Laden (1030) von Daten, welche ein Bild repräsentieren, in das Array;
Verändern (1040) von welchen der Lichtmodulationselemente in Reaktion auf die Daten zum Transferieren einer Instanz des Bildes auf ein Substrat;
Anlegen (1050) von Abtastsignalen an die Abtastleitungen zum Schieben der Daten zwischen den Lichtmodulationselementen; und
Verändern (1060) von welchen der Modulationselemente in Reaktion auf die Daten, die in diese hinein verschoben wurden, zum Transferieren einer anderen Instanz des Bildes auf das Substrat.

10. Verfahren nach Anspruch 9, wobei mindestens einer der Sätze zusätzlich welche der Lichtmodulationselemente, die orthogonal benachbart in dem Array positioniert sind, und welche der Lichtmodulationselemente, die diagonal benachbart in dem Array positioniert sind, aufweist;
wobei orthogonal benachbarte Schaltungselemente in derselben Spalte, aber in verschiedenen benachbarten Reihen, oder in derselben Reihe aber in verschiedenen benachbarten Spalten des Arrays positioniert sind.

11. Verfahren nach Anspruch 9, wobei das Anlegen ferner enthält:
Anlegen (920) eines ersten Abtastsignals an erste der Lichtmodulationselemente in einer ersten Reihe;
in Reaktion auf das erste Abtastsignal, Schieben (930) der Daten aus den ersten der Lichtmodulationselemente in der ersten Reihe heraus;
Anlegen (940) eines zweiten Abtastsignals an zweite der Lichtmodulationselemente in der ersten Reihe und an erste der Lichtmodulationselemente in einer zweiten Reihe, welche benachbart zu den ersten der Lichtmodulationselemente in der ersten Reihe sind;
in Reaktion auf die zweiten Abtastsignale, Verschieben (950) der Daten von den ersten der Lichtmodulationselemente in der zweiten Reihe zu den ersten der Lichtmodulationselemente in der ersten Reihe; und
in Reaktion auf das zweite Abtastsignal, Schieben (960) der Daten aus den zweiten der Lichtmodulationselemente in der ersten Reihe heraus.

## Revendications

1. Circuit électronique ayant des éléments (310) de circuit disposés de façon à former un réseau orthogonal (300) comprenant des rangées et (550) et des colonnes (560), lesdits éléments (310) de circuit étant modifiables en réponse à des données (222) stockées dans ceux-ci et conçus pour décaler des données (222) entre ceux-ci, le circuit électronique comprenant :
une ligne stroboscopique (600) couplée électriquement à un ensemble desdits éléments (310) de circuit pour fournir à celui-ci un signal stroboscopique (402) de sorte que lesdits éléments (310) de circuit, situés dans ledit ensemble, décalent les données (222) vers certains desdits éléments (310) de circuit en dehors dudit ensemble, ledit ensemble comprenant au moins deux éléments desdits éléments (310) de circuit positionnés de façon adjacente diagonalement l'un par rapport à l'autre dans le réseau (300) ;
dans lequel les éléments de circuit adjacents diagonalement sont positionnés de façon non orthogonale dans différentes rangées adjacentes et différentes colonnes adjacentes dudit réseau (300).

2. Circuit électronique selon la revendication 1,
dans lequel ledit ensemble comprend en outre certains desdits éléments (310) de circuit positionnés de façon adjacente orthogonalement dans le réseau (300) et certains des éléments (310) de circuit positionnés de façon adjacente diagonalement dans le réseau (300) ; et
dans lequel les éléments de circuit adjacents orthogonalement sont positionnés dans la même colonne mais dans des rangées adjacentes différentes, ou dans la même rangée mais dans des colonnes adjacentes différentes dudit réseau (300).

3. Circuit électronique selon la revendication 2,
dans lequel la ligne stroboscopique (600) est couplée électriquement à un premier élément et à un deuxième élément desdits éléments (310) de circuit, lesdits premier et deuxième éléments desdits éléments (310) de circuit étant adjacents horizontalement, ladite ligne stroboscopique (600) étant en outre couplée électriquement à un troisième élément desdits éléments (310) de circuit adjacents diagonalement audit deuxième élément desdits éléments (310) de circuit ; et
dans lequel les éléments de circuit adjacents horizontalement sont positionnés dans la même rangée mais dans des colonnes adjacentes différentes dudit réseau (300).

4. Circuit électronique selon la revendication 1, dans lequel lesdits éléments (310) de circuit sont conçus pour décaler des données (222) bidirectionnellement entre certains éléments desdits éléments (310) de circuit situés orthogonalement; et dans lequel les éléments situés orthogonalement sont positionnés dans la même colonne mais dans des rangées différentes, ou dans la même rangée mais dans des colonnes différentes dudit réseau.

5. Circuit électronique selon l'une quelconque des revendications 1 à 4, dans lequel lesdits éléments (310) de circuit sont des éléments de modulation de lumière, lesdits éléments (310) de modulation de lumière comprenant :
des éléments (302) de mémoire conçus pour stocker les données (222) et décaler les données (222) entre ceux-ci ; et
des commandes (304) de pixel conçues pour modifier l'état d'éléments respectifs desdits éléments (310) de modulation de lumière en réponse aux données (222) stockées dans les éléments respectifs des éléments (302) de mémoire.

6. Circuit électronique selon la revendication 5, dans lequel chacun desdits éléments (302) de mémoire comprend en outre un noeud (322) de sortie couplé électriquement à ladite commande (304) de pixel respective et à un noeud (306) d'entrée d'un élément supplémentaire desdits éléments (302) de mémoire.

7. Circuit électronique selon l'une quelconque des revendications 1 à 6, dans lequel :
ledit circuit électronique comprend en outre des lignes stroboscopiques supplémentaires (600) ; et
lesdites lignes stroboscopiques (600) sont conçues dans un premier modèle couvrant un premier groupe (700) desdits éléments (310) de circuit et dans un deuxième modèle couvrant un deuxième groupe (710) desdits éléments (310) de circuit, le deuxième modèle reproduisant à l'identique le premier modèle.

8. Circuit électronique selon la revendication 1, dans lequel ledit circuit électronique comprend en outre :
des lignes stroboscopiques (600) ; et
un registre à décalage (650) connecté électriquement auxdites lignes stroboscopiques (600) pour y appliquer des signaux stroboscopiques (602) séquentiellement.

9. Procédé de réalisation de photolithographie, ledit procédé comprenant :
une fourniture (1020) d'un réseau orthogonal d'éléments de modulation de lumière, ledit réseau comprenant des rangées, des colonnes et des lignes stroboscopiques couplées électriquement à des ensembles respectifs desdits éléments de modulation de lumière, au moins un desdits ensembles comprenant certains des éléments de modulation de lumière positionnés de façon adjacente diagonalement l'un par rapport à l'autre dans ledit réseau ; dans lequel les éléments de circuits adjacents diagonalement sont positionnés de façon non orthogonale dans différentes rangées et dans différentes colonnes adjacentes dudit réseau ;
un chargement (1030) de données représentant une image dans ledit réseau ;
une modification (1040) de certains des éléments de modulation de lumière en réponse auxdites données pour transférer une instance de l'image sur un substrat ;
une application (1050) de signaux stroboscopiques auxdites lignes stroboscopiques pour décaler lesdites données entre lesdits éléments de modulation de lumière ; et
une modification (1060) de certains des éléments de modulation de lumière en réponse auxdites données décalées dans ceux-ci pour transférer une autre instance de l'image sur le substrat.

10. Procédé selon la revendication 9, dans lequel au moins un ensemble desdits ensembles comprend en outre certains desdits éléments de modulation de lumière positionnés de façon adjacente orthogonalement dans ledit réseau et certains desdits éléments de modulation de lumière positionnés de façon adjacente diagonalement dans ledit réseau ;
dans lequel les éléments de circuits adjacents orthogonalement sont positionnés dans la même colonne mais dans des rangées adjacentes différentes ou dans la même rangée mais dans des colonnes adjacentes différentes dudit réseau.

11. Procédé selon la revendication 9, dans lequel ladite phase d'application comprend en outre :
une application (920) d'un premier signal stroboscopique aux premiers éléments desdits éléments de modulation de lumière dans une première rangée ;
en réponse au premier signal stroboscopique, un décalage (930) des données desdits premiers éléments de modulation de lumière dans ladite première rangée ;
une application (940) d'un second signal stroboscopique aux deuxièmes éléments desdits éléments de modulation de lumière dans ladite première rangée et aux premiers éléments desdits éléments de modulation de lumières dans une deuxième rangée ; adjacent auxdits premiers éléments parmi lesdits éléments de modulation de lumière dans ladite première rangée ;
en réponse audit deuxième signal stroboscopique, un décalage (950) des données provenant desdits premiers éléments desdits éléments de modulation de lumière dans ladite deuxième rangée vers lesdits premiers éléments desdits éléments de modulation de lumière dans ladite première rangée, et en réponse audit deuxième signal stroboscopique, un décalage (960) des données desdits deuxièmes éléments desdits éléments de modulation de lumière dans ladite première rangée.
